# EUROPEAN PATENT SPECIFICATION

(11) **EP 0 672 260 B1**
(45) Date of publication and mention of the grant of the patent: **17.10.2001**
(21) Application number: 94926362.8
(22) Date of filing: 23.09.1994
(51) Int. Cl.: G01R 33/09, G11B 5/02, G11B 5/39

(54) **ARRANGEMENT FOR READING INFORMATION FROM A TRACK ON A RECORD CARRIER COMPRISING A FAST SETTLING READ AMPLIFIER FOR MAGNETO-RESISTIVE HEADS**
VORRICHTUNG ZUM AUSLESEN VON INFORMATIONEN VON EINER SPUR EINES AUFZEICHNUNGSTRÄGERS MIT EINEM SCHNELLSTABILISIERENDEN LESEVERSTÄRKER FÜR MAGNETORESISTIVE KÖPFE
DISPOSITIF DE LECTURE D'INFORMATIONS A PARTIR DE LA PISTE D'UN DISQUE, A AMPLIFICATEUR DE LECTURE A STABILISATION RAPIDE POUR TETES MAGNETORESISTIVES

(30) Priority: 06.10.1993 EP 93202836; 23.06.1994 EP 94201806
(43) Date of publication of application: 20.09.1995
(73) Proprietor: Koninklijke Philips Electronics N.V., 5621 BA Eindhoven (NL); PHILIPS NORDEN AB, 164 85 Stockholm (SE)
(72) Inventor: VOORMAN, Johannes, Otto, NL-5621 BA Eindhoven (NL); VILA LOBOS RAMALHO, Joao, Nuno, NL-5621 BA Eindhoven (NL)
(74) Representative: Hesselmann, Gerardus Johannes Maria
(86) International application number: IB9400292
(87) International publication number: WO9510050

(56) References cited:
- EP-A- 0 595 350
- US-A- 5 122 915
- US-A- 5 270 882

## Description

The invention relates to an arrangement for reading out an information signal from a magnetic record carrier, comprising:
a read head having a magneto-resistive element with a first terminal connected to a first point of constant potential, and with a second terminal,
a bias-current means for supplying a bias-current,
an amplifier circuit comprising an output terminal for supplying the information signal, a first terminal coupled to the bias-current means and to the output terminal, a second terminal coupled to the second terminal of the magneto-resistive element so as to form a series arrangement of the bias-current means, the amplifier circuit and the magneto-resistive element between a second point of constant potential and said first point of constant potential, the amplifier circuit further comprising a first transistor, a feedback circuit having an input terminal coupled to the output terminal of the amplifier circuit and having an output terminal, a load impedance and a capacitor element, a first main flow terminal of the first transistor being connected to the second terminal of the amplifier circuit, a second main flow terminal of the first transistor being coupled to the first terminal of the amplifier circuit, a control terminal of the first transistor being coupled to the output terminal of the feedback circuit, the control terminal being further coupled to the first point of constant potential via at least the capacitor element, the load impedance being coupled to the output terminal of the amplifier circuit.

Such an arrangement is known from document US-A-5 122 915.

A similar arrangement is known from United States Patent No. 5,270,882. In this known arrangement current biasing and current sensing of the magneto-resistive (MR) element is combined, thereby providing a low-noise amplification. Read heads with MR elements and thin film inductive write heads, mounted on arms, are used in mass storage devices such as disk drives. Disk drives are equipped with multiple platters, each side of which is used for writing and reading the information. In modern systems servo patterns are embedded in radial patterns between the data on the disk. Writing of data is interchanged with reading to remain on track. Read-to-write and write-to-read transient times should be as short as possible. The capacitor element and the feedback circuit in the arrangement provide a low bandwidth and therefore the transient response time is intrinsically long. An approach to realize short transient times is to leave the read amplifier powered during writing. This, however, costs extra power. Moreover, crosstalk from the write drivers to the read amplifiers will influence the DC settings of the read amplifiers. The DC-offset caused by the crosstalk is amplified in the read amplifier and may overload the output stages thereof. Similar problems are encountered when the information on the platters is arranged in "cylinders". During reading the system switches from platter to platter without mechanical delay introduced by repositioning of the armstack. To avoid electrical delays head switching should be fast. Powering a read amplifier for each read head is not attractive, in particular in battery operated portable equipment. A second option is to use only one read amplifier and to switch the individual read heads in circuit connection with the read amplifier.

Applying this technique to the known arrangement would seriously limit the speed of switching between the different MR elements. MR elements have large spread in resistance and bias current settings. After each head change the capacitor element in the amplifier circuit has to be charged or discharged to the new desired voltage. However, in order to obtain a sufficiently low cut-off frequency of the feedback circuit, the DC resistance of the feedback circuit should be high. A typical cut-off frequency is 10 KHz. In the known arrangement the feedback circuit is a transconductance stage having a low transconductance Gm. The maximum output current of such a transconductance stage severely limits the speed of charging and discharging of the capacitor element and gives rise to transients with a duration of hundreds of microseconds. This is too long for fast mass storage devices. In the known arrangement the transconductance Gm of the transconductance stage is temporarily increased by increasing its bias current. This, however, causes unacceptable errors because of increased offset of the transconductance stage.

It is an object of the invention to provide a fast settling feedback circuit for use in the known arrangement. In accordance with an aspect of the invention, the known arrangement is characterized in that the feedback means comprises:
voltage buffer means having an input coupled to the input terminal of the feedback circuit and having an output;
a first series resistor connected between the output of the voltage buffer means and the output terminal of the feedback circuit; and
a switch connected in parallel with the first series resistor and operable in response of a control signal.

The voltage buffer means provide the high currents needed to charge or discharge the capacitor element when the series resistor is short circuited by the switch connected in parallel to the series resistor. Only a passive element, that is a bias current free element, is short circuited and no offset is created by the short circuiting. In this way a very fast settling is possible without loosing the desired accuracy in settling of the read amplifier.

A first fast settling arrangement is characterized in that the voltage buffer means comprises a first current source and a second current source, a second transistor having a control terminal connected to a second main flow terminal and a third transistor, a first main flow terminal of the second transistor and a first main flow terminal of the third transistor being interconnected and coupled to the first point of constant potential via the first current source, the second main flow terminal of the second transistor being coupled to the second point of constant potential via the second current source and forming the output of the voltage buffer means, a second main flow terminal of the third transistor being coupled to the second point of constant potential, and a control terminal of the third transistor forming the input of the voltage buffer means and being coupled to the input terminal of the feedback circuit.

The voltage buffer means provide a voltage drop across the first and second terminals of the amplifier which is as small as possible and accurately known. As a consequence the voltage drop across the bias-current generator can be made as large as possible within the available supply voltage. This provides the possibility to design a bias-current source having low noise.

The current that can be sunk by the first current source limits the discharging time of the capacitor element. To improve the settling speed, the arrangement may be further characterized in that the voltage buffer means further comprises a third current source connected between the second main flow terminal of the third transistor and the second point of constant potential and in that the first current source comprises a diode arrangement, a bias resistor and a fourth transistor having a first main flow terminal connected to the first point, a second main flow terminal connected to first main flow terminals of the second and third transistors and a control terminal coupled to the second main flow terminal of the third transistor via the diode arrangement and to the first point via the bias resistor.

The fourth transistor can sink currents which are up to two orders of magnitude larger than the current through the third current source.

The charging time of the capacitor element can be shortened in an arrangement which is characterized in that the voltage buffer means further comprises a fifth transistor and a diode element, a control terminal and a second main flow terminal of the fifth transistor being interconnected and being coupled to the third current source via the diode element, a first main flow terminal of the fifth transistor being connected to the first main flow terminal of the second transistor, and a sixth transistor having a first main flow terminal coupled to the second main flow terminal of the second transistor, a second main flow terminal coupled to the second point and a control terminal coupled to the second main flow terminal of the fifth transistor via the diode element.

The additional components provide a class A/B low-ohmic high-current output buffer circuit for quickly charging the capacitor element via the sixth transistor during settling.

Another preferred fast settling arrangement is characterized in that the first terminal is coupled to the output terminal of the amplifier circuit via a second transistor having a first main flow terminal connected to the first terminal and a second main flow terminal coupled to the output terminal of the amplifier circuit; and in that the voltage buffer means comprises:
a current mirror having an input terminal and an output terminal,
a third transistor having a conductivity opposite to the conductivity of the second transistor
and having a first main flow terminal coupled to the output terminal of the current mirror
and a control terminal connected to receive a reference voltage,
a second series resistor connected between the first main flow terminal of the third transistor and the output terminal of the amplifier circuit,
a fourth transistor of the same type as the first transistor having a control terminal connected to a second main flow terminal, and having a first main flow terminal connected to the first main flow terminal of the first transistor and a
second main flow terminal coupled to a second main flow terminal of the third transistor,
a fifth transistor of the same type as the first transistor having a control terminal and a first main flow terminal connected to the corresponding terminals of the first transistor and having
a second main flow terminal coupled to the input terminal of the current mirror; and
a buffer amplifier having an input connected to the control terminal of the fourth transistor
and an output connected to the first series resistor.

In order to obtain low noise, the first transistor should be large. By cascoding this large transistor with the second transistor the following advantages are obtained. The large first transistor and the bias current generator can have a low output impedance, since they feed their respective currents into a very low-ohmic first main flow terminal of the second transistor. The capacitance between the second main flow terminal and the control terminal of the large first transistor is not Millered. The bias current generator provides lower bias current and a corresponding lower noise because part of the total bias current for the magneto-resistive element is provided by the parallel arranged second transistor. The bias current generator feeds current to a low voltage node, so that a maximum voltage range is available for the bias-current source, so as to enable the bias-current generator to be optimal for low noise.

After settling, the current through the second series resistor is zero and the current through the second transistor can be adjusted by means of a voltage applied to the control terminal of the third transistor.

The inaccuracy which is left is caused by charge injection of the switch which short-circuits the first series resistor. After settling is finished the switch is opened and some capacitive charge is extracted from the capacitor element. This charge is about equal to half the charge in the channel of the switching transistor. This charge extraction can be compensated conventionally by switching a small capacitor which is connected to the capacitor element to the second point of constant potential. However, this causes crosstalk from the power supply voltage to the capacitor element. To avoid these problems the arrangement is characterized in that the switch comprises: first and second switching transistors of a first coductivity type, a first main flow terminal of the first switching transistor being connected to a second main flow terminal of the second switching transistor, a second main flow terminal of the first switching transistor being connected to a first main flow terminal of the second switching transistor; first and second driver transistors of a second conductivity type having first main flow terminals connected to a supply voltage terminal and having control terminals connected to a control input for receiving the control signal, a second main flow terminal of the first driver transistor being connected to the control terminal of the first switching transistor, a second main flow terminal of the second driver transistor being connected to the control terminal of the second switching transistor; third and fourth driver transistors of the first conductivity type having control terminals connected to the control input, a first main flow terminal of the third driver transistor being connected to the second main flow terminal of the first switching transistor, a first main flow terminal of the fourth driver transistor being connected to the second main flow terminal of the second switching transistor, a second main flow terminal of the third driver transistor being connected to the second main flow terminal of the first driver transistor, a second main flow terminal of the fourth driver transistor being connected to the second main flow terminal of the second driver transistor.

This switch arrangement feeds half of the total channel charge of the first and second switching transistors back to the capacitor element and compensates the extraction of charge from the capacitor element.

All embodiments may be used in dual construction in combination with one or two MR elements. In the latter case two elements read the same data track from the record carrier and the non-linearities of the MR elements cancel each other. In the case of two MR elements the noise contribution of the first transistors can be reduced further by coupling the capacitor element of the amplifier circuit of the first arrangement to the second terminal of the amplifier circuit of the second arrangement and the capacitor element of the amplifier circuit of the second arrangement being coupled to the second terminal of the amplifier circuit of the first arrangement. The capacitor elements are cross-coupled to the second terminals of the individual amplifiers instead of to ground. The cross-coupling causes a shunting of the noise resistances of the first transistors and effects a reduced noise voltage contribution of the first transistors.

The above and other features and advantages of the invention will be apparent from the following description of exemplary embodiments of the invention with reference to the accompanying drawings, in which:
Figure 1 shows a known arrangement for reading information from a track on a record carrier,
Figures 2A, 2B, 2C show versions of a feedback circuit for use in the arrangement of Figure 1,
Figures 3A, 3B, 4A, 4B and 5 show versions of an amplifier circuit for use in the arrangement of Figure 1,
Figure 6 shows a balanced arrangement according to the invention,
Figure 7 shows an arrangement having shielding means provided over the electlical connection between the MR element and the amplifier circuit,
Figure 8 shows the reading of information from a track on a disk shaped record carrier,
Figure 9A and 9B show circuit parts that can be coupled together so as to realize a multiplexed read out by means of two or more separate MR elements,
Figure 10 shows the circuit part for realizing a multiplexed read out by means of two or more separate heads, each head having two MR elements,
Figure 11 shows an arrangement according to the invention,
Figure 12 shoes a voltage follower for use in the arrangement of Figure 11,
Figure 13 shows a transistor switch for use in an arrangement according to the invention, and
Figure 14 shows an embodiment of a balanced arrangement according to the invention.

Like reference symbols are employed in the drawings and in the description of the preferred embodiments to represent the same or very similar item or items.

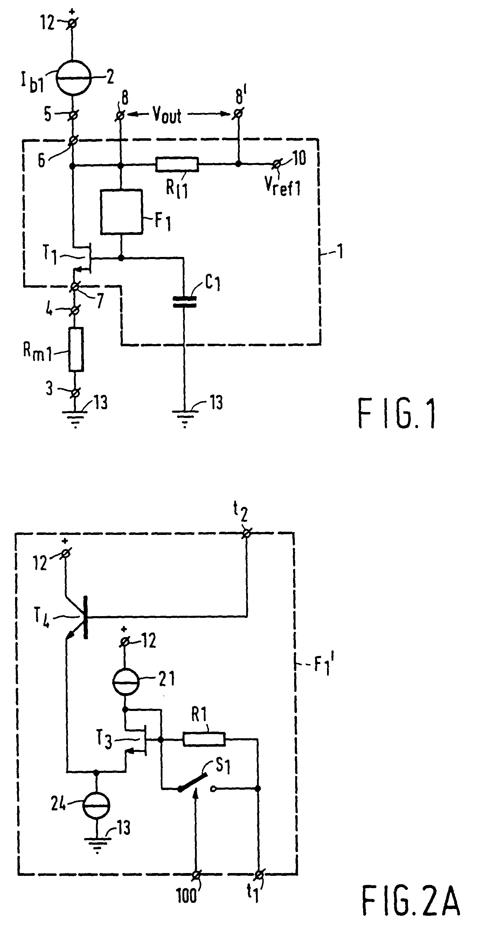

Figure 1 shows the basic circuit construction of the arrangement known from US patent 5,270,882, which comprises a read head (not shown) having a magneto-resistive (MR) element Rₘ₁, a bias-current generator 2 for generating a bias-current I_{b1}, and an amplifier circuit 1. A first terminal 3 of the magneto-resistive element Rₘ₁ is connected to a first point of constant potential 13, which is ground potential. An output 5 of the bias-current generator 2 is coupled to a first terminal 6 of the amplifier circuit 1. A second terminal of the bias-current generator 2 is coupled to a point of constant potential 12 (the positive supply voltage, denoted by +). A second terminal 7 of the amplifier circuit 1 is coupled to a second terminal 4 of the magneto-resistive element Rₘ₁. An output terminal 8,8' is available for supplying the information signal read out.

The amplifier circuit 1 comprises a transistor T₁, a feedback circuit F₁ and a capacitor element C₁. The transistor T₁ is in the form of a MOSFET or a jFET. Its source terminal is coupled to the second terminal 7 of the amplifier circuit 1. Its drain terminal is coupled to the first terminal 6 of the amplifier circuit 1. Its gate terminal is coupled to the first point of constant potential 13, via the capacitor element C₁. Further, the feedback circuit F₁ is coupled between the gate of the transistor T₁ and the terminal 6 of the amplifier circuit 1. The drain terminal of the transistor T₁ is further coupled to a reference point 10 via a load impedance R₁. At the reference point 10 a voltage V_{ref} is available, which needs not be a constant potential, but may vary, as will be explained later. At output terminal 8,8' the voltage occurring over the load impedance R₁ is present. The bias-current generator 2, the amplifier circuit 1, more specifically the transistor T₁ in the amplifier circuit 1, and the MR element Rₘ₁ form a series arrangement between the terminals 3 and 12.

As can be seen from the figure, the MR element Rₘ₁ is connected to ground via its terminal 3. Further, when used in an arrangement for reading an information signal from a disk shaped record carrier (not shown), the disk is also preferably electrically connected to ground. This limits the possibility that a voltage difference can be built up between the head and the disk. This avoids electrical discharges that could otherwise occur between head and disk, which discharges could damage the head.

The MR element Rₘ₁, the amplifier 1 and the bias-current generator 2 form a series arrangement between the two (supply) terminals 3 and 12. Thus, the current supplied by the bias-current generator 2 is fed to the MR element Rₘ₁ so as to bias the MR element, Rₘ₁ as well as to the amplifier circuit 1. This bias current through the amplifier circuit results in a certain noise contribution, which is lower when the current through the amplifier circuit is higher. If the amplifier circuit would be in parallel to the MR element Rₘ₁ and the bias-current generator, a larger current would be needed to bias the MR element Rₘ₁ and to supply the input stage of the amplifier circuit with the current needed to obtain a low noise contribution in the amplifier circuit. Thus the arrangement of Figure 1 produces less noise and requires less bias current, with is a major advantage in the case of battery powered supply voltages.

When the amplifier circuit has only one transistor, such as in the embodiment of Figure 1, instead of two in the case of a long-tailed pair, the amplifier circuit has a lower noise contribution.

Variations in the magnetic field detected by the MR element Rₘ₁ lead to variations in the resistance value of the MR element. The gate of transistor T₁ is coupled to ground for AC signals by means of the capacitor C₁. This means that for AC signals, the terminal 4 of the MR element Rₘ₁ lies virtually to ground. As a result of this, variations in the resistance value of the MR element can only lead to variations in the current through the series arrangement. These current variations are fed via the load impedance Rₗ₁ to the terminal 10, and lead to a voltage variation across the load impedance Rₗ₁. This voltage variation is detected at the terminals 8,8' as the output signal of the amplifier circuit.

The feedback circuit F₁ realizes a low cut-off frequency. In order to enable integration of the capacitor C₁, the resistance value of F₁ should be high. This results in the transistor T₁ acting like a diode for DC signals, so that the bias-current I_{b1} can be fed to the MR element Rₘ₁. The feedback circuit F₁ is an impedance network. In its most simple form, the feedback circuit can be a resistor.

In order to make the arrangement suitable for use at low supply voltages applied to the terminals 3 and 12, it is necessary to make the voltage drop between the terminals 4 and 6 as small as possible, so that a maximum voltage range is available for the bias-current source (2), so as to enable the bias-current source to be optimal for low noise.

Figure 2A shows a further-elaborated version of the feedback circuit F₁, so as to make it high ohmic and to realize a voltage drop across the transistor T₁ which is as small as possible. The feedback circuit F₁ comprises a transistor T₃, which is a MOS transistor, a bipolar transistor T₄ and a resistor R₁. Both transistors T₁ and T₃ are of the same type, MOSfet or jFET. The gate terminal of the transistor T₁ is coupled to the terminal t₁ of the feedback circuit. The terminal t₁ is coupled to the gate terminal of the third transistor T₃ via the resistor R₁. The source terminal of the third transistor T₃ is coupled to the emitter terminal of the fourth transistor T₄. The base terminal of the transistor T₄ is coupled to the terminal t₂ of the feedback circuit, which terminal is coupled to the terminal 6 of the amplifier circuit. The gate and drain terminal of the transistor T₃ are interconnected so as to form a diode. Further, the interconnected gate and drain terminals are coupled to the point 12 of constant potential via a current source 21. The emitter of the transistor T₄ is coupled to the first point of constant potential 13 via a current source 24. Further, the collector of the transistor T₄ is coupled to the second point of constant potential 12. The current sources provide current supply for the transistors T₃ and T₄.

By means of the feedback part of Figure 2A, a voltage shift of -Vₜₕ + V_{d} is obtained between the terminals t₁ and t₂, where Vₜₕ is the threshold voltage of a MOS transistor, such as the transistors T₁ and T₃, and V_{d} is the voltage across a bipolar diode. As a result, the voltage difference between the terminals 6 and 7 of the amplifier circuit of Figure 1, is roughly V_{d}, or substantially 0.7 V.

More specifically, the voltage difference between the terminals 6 and 7 is V_{d} + V_{ch1} - V_{ch2}, where V_{ch1} and V_{ch2} are the channel voltages of the transistors T₁ and T₃ respectively, which are dependent of the drain current through those transistors (V_{ch}= V_{gs} - Vₜₕ, where V_{gs} is the gate-source voltage and Vₜₕ the threshold voltage of a transistor).

Further, the impedance formed by the feedback circuit between the terminals t₁ and t₂ is high-ohmic so as to obtain the desired low value for the cut-off frequency of the lower band edge of the frequency characteristic of the amplifier circuit. The circuit of Figure 2A has current sources coupled to both the positive (12) as the negative (13) supply voltage terminal.

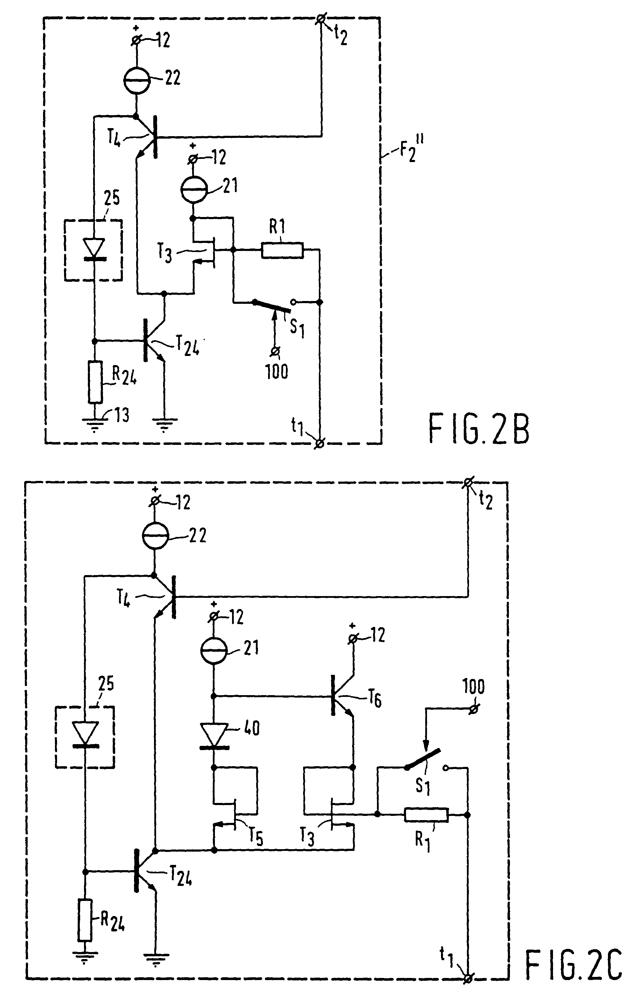

Figure 2B shows a further elaborated version of the feedback circuit of Figure 2A, which has current sources connected to the positive supply terminal only. The circuit of Figure 2B further comprises a diode arrangement 25 of one or more diodes, a bipolar transistor T₂₄, a current source 22 and a resistor R₂₄. The current source 22 is coupled between the point 12 of constant potential and the collector of the transistor T₄, and is further coupled via the diode arrangement 25 to the base terminal of the transistor T₂₄. The base terminal of the said transistor is also coupled to the point 13 of constant potential via the resistor R₂₄. The emitter of the transistor T₂₄ is coupled to the point 13 of constant potential, and its collector is coupled to the interconnected emitter and source of the transistors T₄ and T₃ respectively.

The circuit part formed by the elements 22, 25, R₂₄ and T₂₄ effectively replaces the current source 24 in Figure 2A. The circuits of the Figures 2A and 2B further show a switch S₁ connected in parallel to the resistor R₁. When activating the amplifier circuit of Figure 1, or when the current value through the MR element should be changed, the capacitor C₁ must initially be charged (or discharged) so that the amplifier circuit can settle to the new situation. In order to settle fast, the resistor R₁ is short-circuited by the switch S₁ under the influence of a switching signal applied to the control signal input 100, so that the current for charging the capacitor C₁ can be supplied by the current source 21, or discharging can take place via the current source 24. The charging time of the capacitor C₁ is thus limited by the maximum current that can be supplied by the current source 21, and the discharging time is limited by the maximum current that can be received by the current source 24. Replacing the current source 24 of Figure 2A by the elements 22, 25, R₂₄ and T₂₄ in Figure 2B already offers a shortening of the discharge time, as the transistor T₂₄ can sink currents which are up to two orders of magnitude larger than the current through the current source 22.

Figure 2C shows a feedback circuit in which the charging time of the capacitor C₁ can be shortened. The circuit of Figure 2C further comprises a MOS transistor T₅, a bipolar transistor T₆ and a bipolar diode element 40. The gate and drain terminals of the transistor T₅ are interconnected and both coupled to the current source 21 and to a base terminal of the transistor T₆ via the diode element 40. The source terminals of the transistors T₃ and T₅ are interconnected. A collector terminal of the transistor T₆ is coupled to point 12 of constant potential. An emitter terminal of the transistor T₆ is coupled to the interconnected gate and drain terminals of the transistor T₃. The circuit comprising the transistors T₃, T₆ and T₅ and the diode element 40 form a class-A/B circuit and provides a quicker charging of the capacitor element C₁ during initialisation of the arrangement by means of current supplied by the transistor T₆.

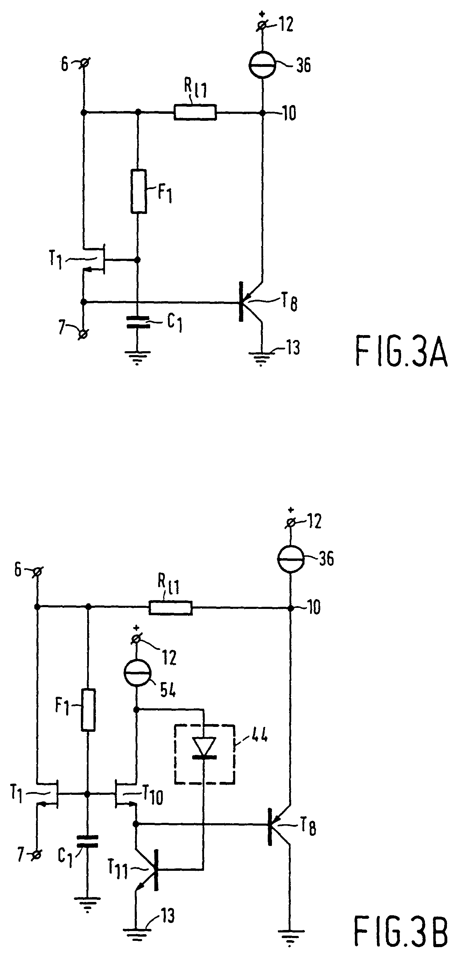

Figure 3A shows a further-elaborated version of the amplifier circuit 1 of Figure 1. The circuit of Figure 3A comprises a bipolar transistor T₈, which has its base terminal coupled to the source terminal of the transistor T₁, its collector to the point 13 of constant potential, and its emitter coupled to the reference point 10. Further a current source 36 is coupled between the reference point 10 and the second point 12 of constant potential. This circuit has the advantage that the DC voltage present at the reference point 10 follows the DC voltage present at the terminal 7 of the amplifier circuit. This means that voltage variations occurring across the MR element Rₘ₁ do not appear across the load resistor Rₗ₁.

The voltage difference between the terminals 7 and 10 is equal to V_{d}. If F₁ is one of the circuits of the Figures 2A, 2B or 2C, the voltage difference between the terminals 6 and 7 equals V_{d} + V_{ch1} - V_{ch2}, see above, so that the DC offset across the load resistor Rₗ₁ is low (V_{ch1} - V_{ch2}). Only voltage variations in the transistor T₁, resulting from the current variations through the transistor T₁, still appear across the load resistor Rₗ₁.

A further improvement of the amplifier circuit of Figure 3A is disclosed in Figure 3B. The amplifier circuit 1 further has a MOS transistor T₁₀ and a bipolar transistor T₁₁. The gate of transistor T₁₀ is connected to the gate of the transistor T₁, the drain is coupled to the point 12 of constant potential via a current source 54, as well as coupled to the base of the transistor T₁₁ via a diode arrangement 44 consisting of one or more series connected diodes. The source of the transistor T₁₀ is coupled to the collector of the transistor T₁₁ as well as to the base of the transistor T₈. The emitter of the transistor T₁₁ is coupled to the point 13 of constant potential.

The voltage difference between the gate of the transistor T₁ and the terminal 10 equals V_{gs} - V_{d}, where V_{gs} is the gate-source voltage of the transistor T₁₀. If F₁ is again one of the circuits of the Figures 2A, 2B or 2C, the voltage difference between the gate of the transistor T₁ and terminal 6 equals V_{gs}' - V_{d}, where V_{gs}' is the gate-source voltage of the transistor T₃. The voltage across the load resistor Rₗ₁ now equals V_{gs}' - V_{gs}. If the current through transistor T₁₀ is made equal to the current through the transistor T₃, and further the transistors T₁₀ and T₃ have equal dimensions, the said voltage becomes practically zero, independent of the value of the MR bias current.

It will be clear that, instead of the combination of the current source 54, the diode arrangement 44 and the transistor T₁₁, a current source could have been coupled between the emitter of the transistor T₁₁ and ground potential.

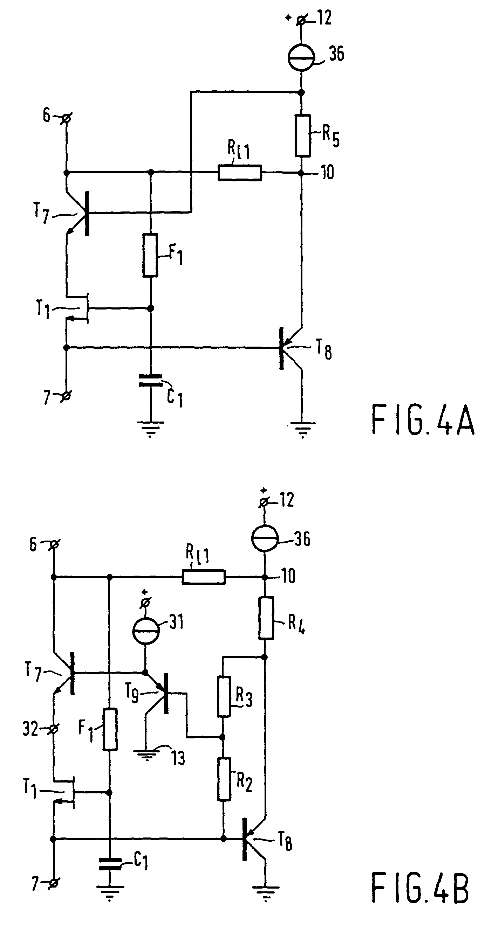

Figure 4A shows a further improvement of the amplifier circuit of Figure 3A. The amplifier circuit comprises a bipolar transistor T₇ which is coupled between the drain terminal of the transistor T₁ and the terminal 6. Its base terminal is coupled to the point 12 of constant potential via the current source 36, and to the point 10 via a resistor R₅.

By means of the transistor T₇, the transistor T₁ is cascoded in order to get a higher output impedance at the terminal 6 and to prevent the Millering of the drain-gate capacitance of transistor T₁.

Figure 4B shows an alternative of the amplifier circuit of Figure 4A. It additionally comprises a transistor T₉, resistors R₂, R₃ and R₄ and a current source 31. The base terminal of the transistor T₇ is connected to an emitter terminal of the transistor T₉, a base terminal of which is coupled to the source terminal of the transistor T₁ via the resistor R₂. The collector of the transistor T₉ is coupled to the point 13 of constant potential. The emitter of the transistor T₉ is further coupled to the point 12 of constant potential via the current source 31. The base of the transistor T₉ is coupled to the emitter of the transistor T₈ via the resistor R₃, and to the reference point 10 via the resistors R₃ and R₄.

Further, the construction of the transistors T₇ and T₉ provides a voltage at the interconnection node 32 of the emitter of transistor T₇ and the drain of transistor T₁, which is roughly half way between the voltages present on the terminals 7 and 6. This means that a voltage difference of V_{d}/2 is present between the node 32 and the terminal 7, and between the nodes 32 and the terminal 6, as the voltage difference between the terminals 6 and 7 is V_{d}, as explained previously.

It should be noted that Figure 4A and Figure 4B are derived from Figure 3A by adding the cascode transistor T₇, using different biasing schemes. The same cascode principles can be added to the circuit of Figure 3B.

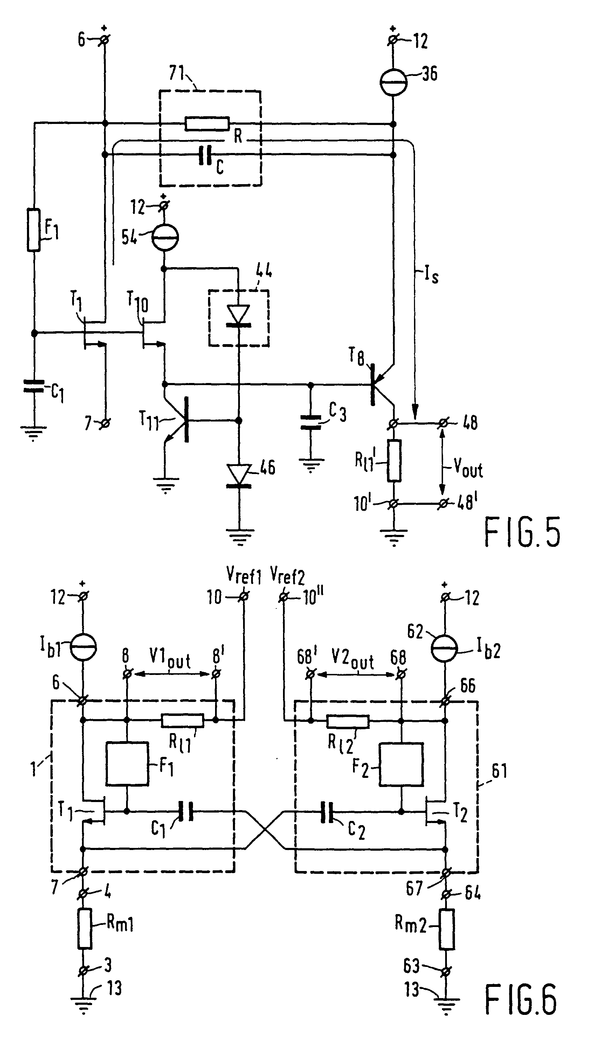

Figure 5 shows another embodiment of the amplifier circuit. The amplifier circuit of Figure 5 is a further elaboration of the circuit of Figure 3B. Also in this case cascoding can be applied.

The amplifier circuit of Figure 5 differs from the amplifier circuit of Figure 3B in that it further comprises an impedance network 71. Further, diode 46 and a capacitor element C₃ are present. An emitter terminal of the transistor T₈ is coupled to the first terminal 6 of the amplifier circuit via the impedance network 71, as well as to an output terminal of the current source 36. The collector terminal of the transistor T₈ is coupled to a terminal of the load impedance Rₗ₁'. From the Figure, it appears that the reference point 10 in Figure 3B has now become the reference point 10', which has the same potential as the first point 13 of constant potential, that is ground.

The base terminal of the transistor T₁₁ is coupled via the diode 46 to the point 13 of constant potential. The base terminal of the transistor T₈ is coupled to the first point 13 of constant potential via the capacitor element C₃.

Signal currents Iₛ generated by the MR element Rₘ₁ flow from the MR element Rₘ₁ to the terminal 7, via the transistor T₁, the impedance network 71 and the transistor T₈ to the load impedance Rₗ₁, the terminals 48,48' now forming the output terminal of the arrangement. The capacitor element C₃ filters out a noise component that would otherwise be present in the output signal at the output terminal 48,48'.

It should be noted that the embodiments of the Figures 3A, 3B, 4A and 4B, where the output 8,8' of the amplifier circuit is connected to the terminals of the load impedance Rₗ₁, are particularly suitable for use in an arrangement provided with only one MR element Rₘ₁. The embodiment of Figure 5, where the output or the amplifier circuit is formed by the terminals 48,48' is particularly useful in an arrangement having two MR elements Rₘ₁,Rₘ₂.

It should be further noted that likewise the circuits of the Figures 3A, 3B, 4A and 4B could have been provided with a load impedance Rₗ₁' coupled between the collector of the transistor T₈ and the point 13 of constant potential, which is preferred for an arrangement having two MR elements.

In such arrangements provided with two MR elements Rₘ₁ and Rₘ₂, see also the arrangement of Figure 6, each MR element is coupled to an amplifier circuit of a type as described above. The output of such an arrangement is then formed by the terminals 48 of each of the two amplifier circuits.

Figure 6 shows an embodiment of an arrangement which is in the form of a balanced circuit, and comprises two MR elements. The arrangement comprises a read head having a first and a second magneto-resistive element Rₘ₁ and Rₘ₂ respectively. Both MR elements Rₘ₁ and Rₘ₂ of the head scan the same track (not shown), so that they read the same signal from the track. The left hand part of the circuit shown in Figure 6 is largely identical to the circuit diagram shown in Figure 1. A first terminal 63 of the MR element Rₘ₂ is connected to the first point 13 of constant potential (ground). Further, a second bias-current generator 62 is available, having an output for supplying a second bias current (I_{b2}). Another terminal of the bias-current generator 62 is coupled to the terminal 12, on which the positive supply voltage is available. The amplifier circuit 61 has a first terminal 66 coupled to the output of the second bias-current generator 62 and a second terminal 67 coupled to the second terminal 64 of the second magneto-resistive element Rₘ₂. The second bias-current generator 62, the second amplifier circuit 61 and the second magneto-resistive element Rₘ₂ form a series arrangement between the terminals 12 and 13.

The second amplifier circuit 61 comprises a transistor T₂, which is in the form of a MOS transistor, a load impedance Rₗ₂, a feedback circuit F₂ and a capacitor element C₂. The source terminal of the transistor T₂ is coupled to the second terminal 67 of the amplifier circuit 61. The drain terminal of the transistor T₂ is coupled to the first terminal 66 of the amplifier circuit 61. The gate terminal of the transistor T₂ is coupled to the first terminal 66 of the amplifier circuit 61, via the feedback circuit F₂. Further, the gate terminal of the transistor T₂ is coupled to the source terminal of the transistor T₁ via the second capacitor element C₂. Moreover, the gate terminal of the transistor T₁ is coupled to the source terminal of the transistor T₂ via the capacitor element C₁. It is however also possible to couple both capacitor elements to the point 13 of constant potential (ground). However the cross-coupled connection of the capacitor elements, as shown in Figure 6, is preferred as it reduces the noise. A load impedance Rₗ₂ is coupled between the terminal 66 of the amplifier circuit 61 and a reference point 10", on which point a reference voltage V_{ref2} is available. The voltage V_{ref2} may differ from the voltage V_{ref1}, as the DC voltages across the MR elements Rₘ₁ and Rₘ₂ can be different owing to mismatch of the resistance of the MR elements and/or unequal MR bias currents I_{b1} and I_{b2}.

Constructions similar to the feedback circuits of the Figures 2A, 2B or 2C can be used for the feedback circuit F₂ of Figure 6. It will further be clear that the amplifier circuits as shown in the Figures 3A, 3B, 4A, 4B and 5 can be used for the amplifier circuit 61 of Figure 6.

It has been said previously that the two MR elements Rₘ₁, Rₘ₂ read a signal from the same track. When the two output signals V₁ₒᵤₜ and V₂ₒᵤₜ are added, an output signal which is the sum of both signals will appear, and systematic DC offset in both amplifier circuits 1 and 61 will cancel. This systematic DC offset is for example the term V_{ch1}-V_{ch2} between the nodes 6 and 10 (Figure 3A), discussed previously, or the DC voltage across the grounded load resistors, such as Rₗ₁' in Figure 5.

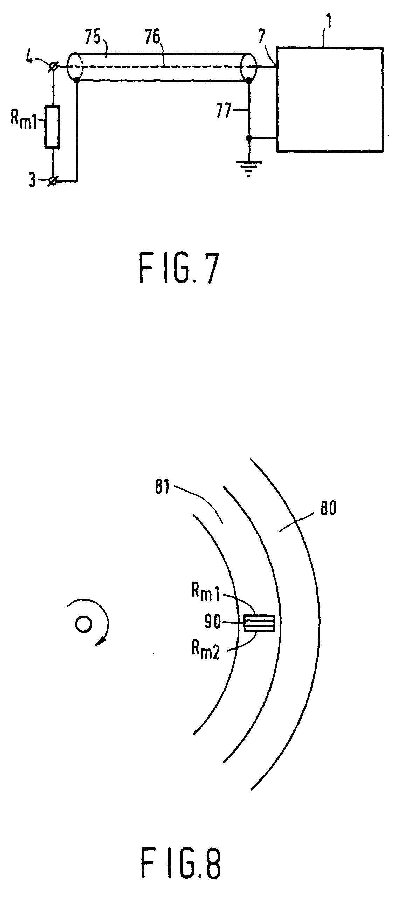

Figure 7 shows a further improvement of the arrangement having only one MR element. Figure 7 shows the provision of an electro-magnetic shielding 75 over the electrical connection 76 connecting the terminal 4 of the MR element Rₘ₁ with the terminal 7 of the amplifier circuit 1. The shielding 75 is connected to ground via the electrical connection 77. This shielding prevents electro-magnetic stray fields from disturbing the signals read out by means of the head. The shielding can be realized by means of a kind of coaxial cable. However, also simpler constructions can be used for the shielding means, for instance by wrapping the ground conductor around the signal carrying conductor.

Figure 8 shows a top view of the reading out of information from a track on the disk shaped record carrier 80, by means of a read head having two MR elements. Both MR elements Rₘ₁ and Rₘ₂ are coupled together via an insulating layer 90 and both read the full width of the same track 81.

The arrangements disclosed are preferably intended for hard disk applications, for low supply voltages, such as 3.3 V ± 10% and 5.0 V ± 10%. The bias current can be kept low, as the bias current is practically only needed for the MR element. A low-noise amplification of the signals read out can be obtained. The record carrier is preferably connected to ground via an electrical connection.

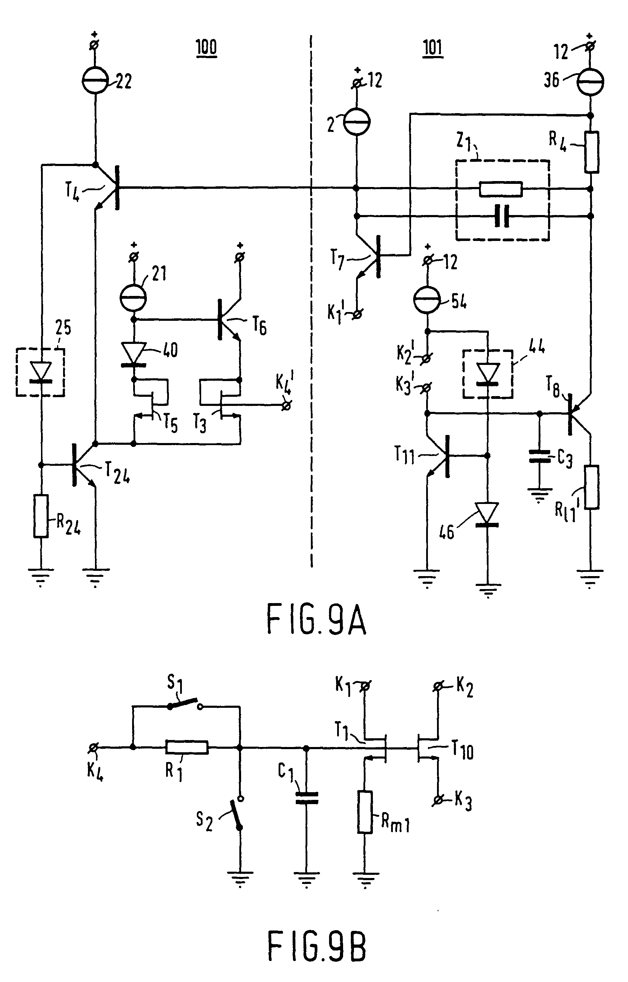

Figures 9A and 9B show units that can be coupled together in order to realize a multiplexed read out of information from a track on a record carrier by means of two or more MR elements. Figure 9A shows the circuit part which is common to all MR elements and Figure 9B shows the circuit part for each MR element. Only one such circuit part for the MR element Rₘ₁ is shown. For other MR elements the circuit part of Figure 9B should be copied. The common circuit part of Figure 9A shows at the left side of the vertical broken line a circuit part indicated by the reference numeral 100, which circuit part is largely resembles the feedback circuit of Figure 2C. It lacks the resistor R₁ and the switch S₁, which are included in the circuit part shown in Figure 9B. At the right hand side of the broken line, the circuit part 101 largely resembles the amplifier circuits of Figure 4A and 5.

Two or more of the circuits of Figure 9B can be coupled to the common circuit of Figure 9A by interconnecting the terminal k₁' of the common circuit of Figure 9A with the terminals k₁ of the two or more circuit parts of Figure 9B. In the same way the terminals k₂ and k₂', k₃ and k₃', and k₄ and k₄' are interconnected. Multiplexing is realized by means of the switches S₂ in each of the circuits of Figure 9B. One of the switches S₂ of one of the circuits of Figure 9B coupled to the common circuit of Figure 9A, is opened and the switches S₂ of the other circuits of Figure 9B are closed. In that situation, all of the MR elements Rₘ₁ are switched off except one, so that the signal read by that MR element is applied to and amplified by the circuit part of Figure 9A.

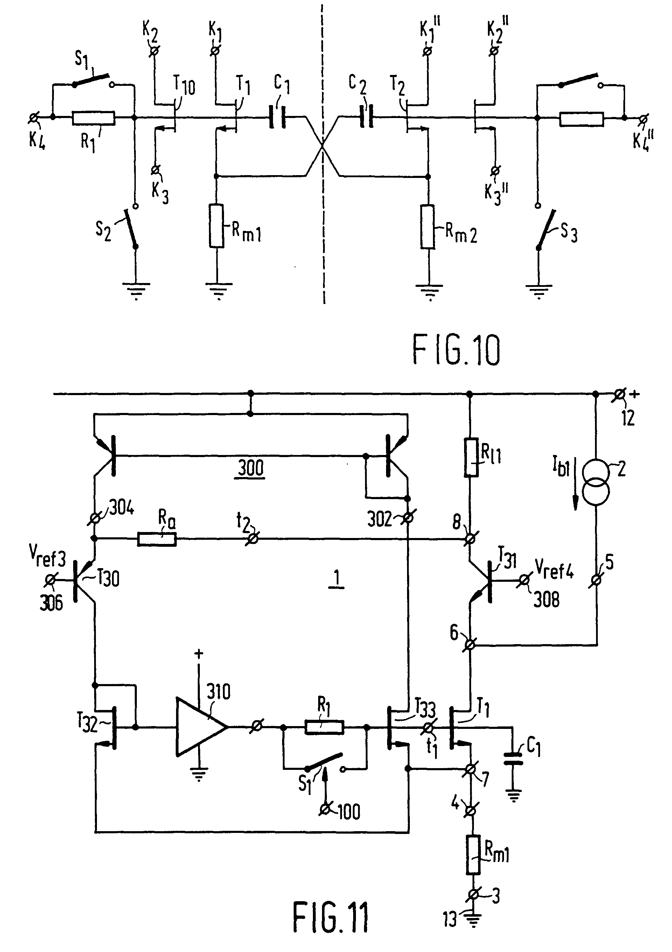

Figure 10 shows the circuit part of a balanced version of the head, comprising two MR elements Rₘ₁ and Rₘ₂, in a fashion as shown in Figure 6, where multiplexing is made possible. Figure 10 shows the circuit part including the two MR elements Rₘ₁, Rₘ₂ that is separate for each of the heads comprising two MR elements. The circuit part is largely mirror symmetrical, where the left hand part, left from the vertical broken line in Figure 10, is the same as the circuit part of Figure 9B. The circuit part of the transistors T₁ and T₂ and the capacitors C₁ and C₂ is identical to the corresponding circuit part of those elements in Figure 6.

The circuit part of Figure 9A is doubled, so as to obtain the common circuit part for each of the heads. The circuit part of Figure 9A is thus coupled to the left hand part of the circuit of Figure 10, as has been explained above for the interconnection between the circuits of Figure 9A and 9B. The right hand circuit part of Figure 10 is coupled to a circuit part identical to the circuit part of Figure 10A. Switching the head of Figure 10 into the circuit means that both switches S₂ and S₃ are in the open position as shown. Consequently, the corresponding switches S₂ and S₃ of the other heads coupled to the common circuit are in their closed position. Switching the head off is realized by closing both switches S₂ and S₃.

Figure 11 shows an alternative further-elaborated version of the amplifier circuit 1 of Figure 1. The first terminal 6 of the amplifier circuit 1 is directly connected to the output 5 of the bias current generator 2. However, in contradistinction to Figure 1, the terminal 8, which interconnects the load impedance R₁₁ and the feedback circuit F₁, is connected to the drain of the transistor T₁ via the collector-emitter path of a NPN transistor T₃₁. The emitter of transistor T₃₁ is connected to the drain of transistor T₁, the base is connected to a reference point 308 which supplies a reference voltage V_{ref4} and the collector is coupled to the load impedance Rₗ₁. The transistors T₁ and T₃₁ form a cascoded output stage. The collector of transistor T₃₁ may be connected to the load impedance Rₗ₁ via the collector-emitter path of an optional further NPN cascode transistor (not shown). The feedback circuit F₁ between the terminals t₂, which is connected to the output terminal 8, and the terminal t₁, which is connected to the gate of transistor T₁, comprises a current mirror 300; a PNP transistor T₃₀, having its emitter coupled to an output terminal 304 of the current mirror 300 and having its base connected to a reference voltage terminal 306 to receive a reference voltage V_{ref3};
a series resistor Rₐ connected between the emitter of the transistor T₃₀ and the output terminal 8 of the amplifier circuit 1; a diode connected transistor T₃₂ of the same type as transistor T₁, having its source connected to the source of transistor T₁ and its drain coupled to the collector of transistor T₃₀; a transistor T₃₃, also of the same type as transistor T₁, having its gate and source connected to the gate and source of the transistor T₁ and having its drain coupled to an input terminal 302 of the current mirror 300; a voltage following buffer amplifier 310 having an input connected to the gate of transistor T₃₂; a high-ohmic series resistor R₁ connected between an output of the buffer amplifier 310 and the gate of transistor T₁; and a controllable switch S₁ connected in parallel with the series resistor R₁.

The resistance of resistor R₁ is typically 1 MOhm, the capacitance of the capacitor C₁ is typically 200 pF, values that can be integrated. The bias current generator 2 can be implemented with a programmable current output digital to analog converter (IDAC) for supplying the bias current of the magneto-resistive element Rₘ₁. In the arrangement of Figure 11 the IDAC supplies the variable part of the MR element's bias current, for instance 0 mA to 15.5 mA in steps of 0.5 mA, whereas a fixed current, for example 5 mA, is provided by the low-ohmic cascode output stage T₃₁. In order to obtain low noise, transistor T₁ should be large. The advantages of the cascoding arrangement are: (1) the large low-noise MOS transistor T₁ and the IDAC can have a low output impedance, since they feed their respective currents into a very low-ohmic emitter of the cascode transistor T₃₁; (2) the drain-to-gate capacitance of the large transistor T₁ is not Millered; (3) the IDAC provides lower bias current and a corresponding lower noise; and (4) the IDAC feeds its current to a low voltage node, which permits a high voltage drop across the IDAC which results in a further reduction of noise.

The transistors T₃₂ and T₃₃ are small in respect of transistor T₁, but are of the same type. The gate-source voltage of transistor T₁ is copied to transistor T₃₂ by means of transistor T₃₃ and current mirror 300. Therefore on both sides of resistor R₁ the DC voltages with respect to ground are substantially equal. During settling, a suitable control signal closes the switch S₁ across resistor R₁ and buffer amplifier 310 provides the high charge or discharge current for recharging capacitor C₁. Only passive components, i.e. the resistor R₁, are short circuited during settling.

After settling the current in resistor R₁ is zero. The current in resistor Rₐ is zero as well, because any current through resistor Rₐ is counteracted by an increased or decreased current through transistor T₁ until the current through resistor Rₐ is zero. The voltage at the output terminal 8 is equal to the reference voltage V_{ref3} at the base of transistor T₃₀ plus the base-emitter voltage V_{be} of transistor T₃₀. The voltage drop across the load resistor R₁₁ is thus equal to V_{cc}-D-V_{ref3}. This means that the fixed part of the bias current through the MR element can be adjusted by means of the reference voltage V_{ref3}.

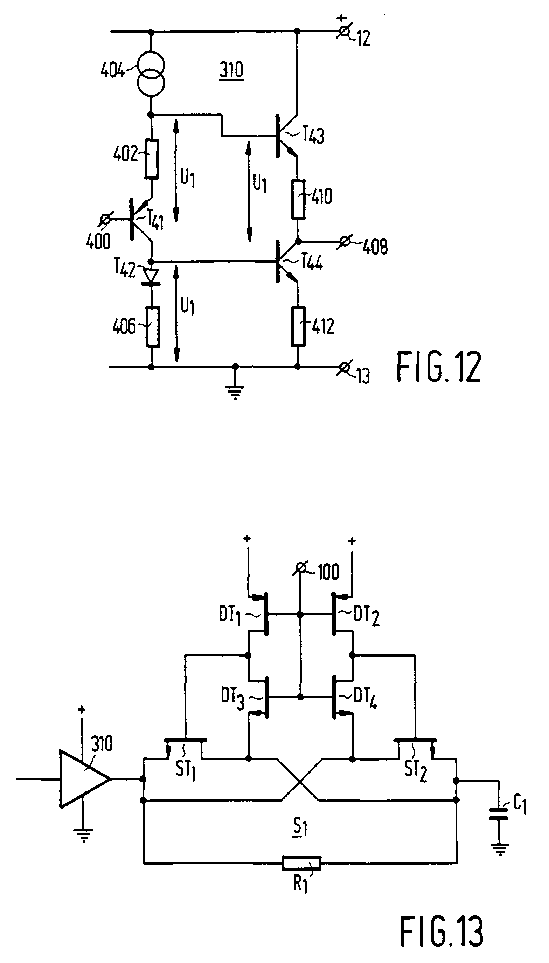

Figure 12 shows an example of a voltage follower 310 for use in the arrangement of Figure 11. The input 400 of the follower 310 is connected to the base of a PNP transistor T₄₁. The emitter of this transistor is coupled to the point 12 of constant potential via the series arrangement of a resistor 402 and a bias current source 404. The collector of transistor T₄₁ is connected to point 13 (ground) via a series arrangement of a diode connected PNP transistor T₄₂ and a resistor 406. The resistors 402 and 406 have equal resistances. The transistors T₄₁ and T₄₂ have equal emitter areas. So in steady state the voltage drop U₁ caused by current source 404 across the series arrangement of the base-emitter junction of transistor T₄₁ and resistor 402 is equal to the voltage drop across the series arrangement of the diode connected transistor T₄₂ and resistor 406. The interconnection node of the current source 404 and the resistor 402 is connected to the base of a NPN transistor T₄₃. The collector of this transistor is coupled to point 12 and the emitter is connected to the output 408 of the follower 310 via a resistor 410. The interconnection node of collector of transistor T₄₂ and the series connection of transistor T₄₂ and resistor 406 is connected to the base of a NPN transistor T₄₄, the collector of which is connected to the output 408 and the emitter of which is connected to ground via a resistor 412. The resistors 410 and 412 have equal resistances and the transistors T₄₃ and T₄₄ have equal dimensions. In steady state the voltage drop U₁ across the series arrangement of the base-emitter junction of transistor T₄₄ and resistor 412 is equal to the voltage drop across the series arrangement of the base-emitter junction of transistor T₄₃ and resistor 410.

After settling, when no current flows any more in the output 408, the voltage difference between the input 400 and the output 408 is zero. During settling high charge currents can be provided to the output 408 by transistor T₄₃ or high discharge currents by transistor T₄₄ by selecting suitable low resistance values for the resistors 410 and 412. The voltage follower of Figure 12 therefore enables fast and accurate settling as it provides high recharge currents during settling and low offset between input and output after settling.

The switch S₁ in the arrangement shown in Figure 11 can be implemented conventionally with a MOS transistor. The main inaccuracy which is still left then is caused by charge injection of the switch S₁ into the capacitor C₁. After fast settling is finished, the switch S₁ is opened and some capacitive charge is extracted from capacitor C₁. This charge is about equal to half the charge in the channel of the MOS transistor. This charge extraction would be normally compensated by switching a small additional capacitor which is connected between capacitor C₁ and point 12. However, this causes crosstalk from the supply voltage to the capacitor C₁.

Figure 13 shows a MOS switching arrangement S₁ which feeds half of the channel charge back to capacitor C₁ and compensates the charge extraction from capacitor C₁. The switch S₁ is composed of first, ST₁, and second, ST₂, NMOS switching transistors. The source of the first switching transistor ST₁ is connected to the drain of the second switching transistor ST₂, and the drain of the first switching transistor ST₁ is connected to the source of the second switching transistor ST₂. The switching transistors ST₁ and ST₂ are driven by first, DT₁, and second, DT₂, PMOS driver transistors. These PMOS transistors have sources connected to the point 12 and have gates connected to the control input 100 for receiving a control signal. The drain of the first driver transistor DT₁ is connected to the gate of the first switching transistor ST₁, and the drain of the second driver transistor DT₂ is connected to the gate of the second switching transistor ST₂. Further, third DT₃ and fourth DT₄ NMOS driver transistors are provided. These NMOS driver transistors have their gates connected to the control input 100, whereas the source of the third driver transistor DT₃ is connected to the drain of the first switching transistor ST₁, the source of the fourth driver transistor DT₄ to the drain of the second switching transistor ST₂, the drain of the third driver transistor DT₃ to the drain of the first driver transistor DT₁, and the drain of the fourth driver transistor DT₄ to the drain of the second driver transistor DT₂.

If the control signal at control terminal 100 is low (ground), then the PMOS driver transistors DT₁ and DT₂ are conductive and switch on the switching transistors ST₁ and ST₂ and resistor R₁ is short-circuited for fast settling. The settling is finished by applying a high voltage at the control terminal 100. In that case the PMOS driver transistors DT₁ and DT₂ are cut off and the NMOS driver transistors DT₃ and DT₄ are made conductive. The conductive driver transistor DT₃ provides a conduction path from the gate of the switching transistor ST₁ to the capacitor C₁ and allows half the channel charge of switching transistor ST₁ to flow into the capacitor C₁, thereby cancelling the half of the channel charge of switching transistor ST₂ which is extracted from the capacitor C₁. The other half of the channel charge of switching transistor ST₂ is conducted by driver transistor DT₄ to the low-ohmic output of buffer 310, which also absorbs the other half of the channel charge of switching transistor ST₁. It will be clear that the switching arrangement of Figure 12 can also be employed in the above mentioned embodiments.

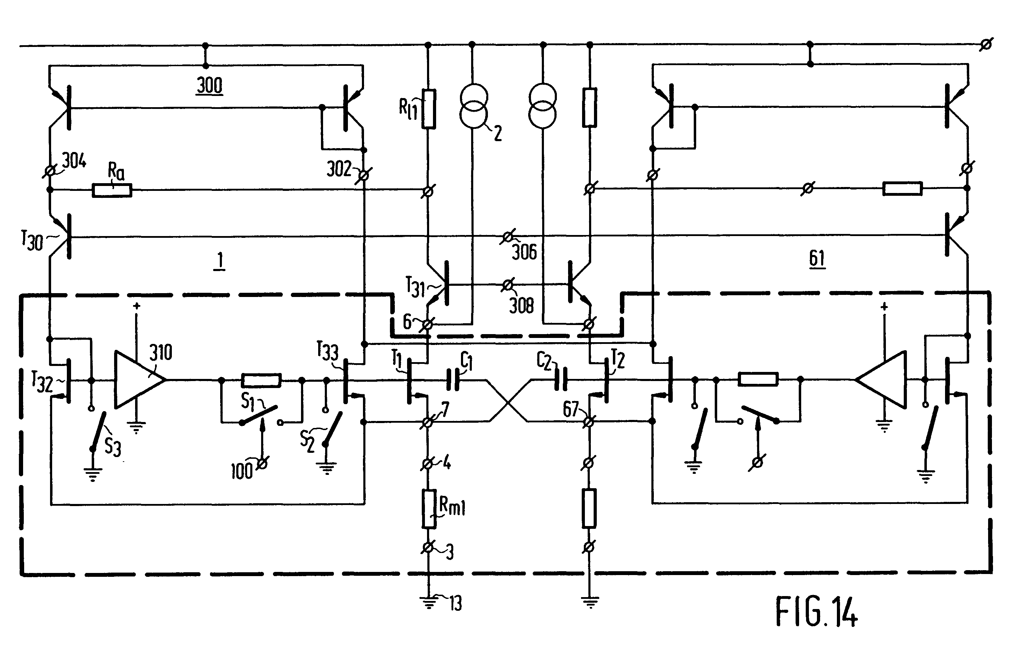

Figure 14 shows a balanced version of the arrangement of Figure 11. The two amplifiers 1 and 61, in particular the capacitors C₁ and the corresponding capacitor C₂ of the second amplifier 61, are interconnected in a similar fashion as shown in Figure 6. At high frequencies the capacitors C₁ and C₂ form a short circuit and shunt the two individual equivalent source noise resistors Rₙ of the MOS transistors T₁ and T₂. Rₙ is about equal to Rₒ, Rₒ being the inverse of the transconductance of the transistors T₁ and T₂. The total effective noise resistance in the first amplifier 1 of the arrangement of Figure 12 is Rₘ₁+Rₙ/2 instead of Rₘ₁+Rₙ of the first amplifier 1 of the arrangement of Figure 11. The balanced version thus provides a reduction of noise.

One of the MR elements Rₘ₁ or Rₘ₂ may be omitted when using single stripe MR read heads. In that case terminal 7 or 67 is coupled to ground 13. The input terminals of the current mirrors may be advantageously interconnected to cancel signal components.

In order to enable switching of heads, two further switches are provided in each half of the balanced arrangement. One further switch S₂ for connecting the gate of transistor T₁ to ground and a second parallel-operated further switch S₃ for connecting the gate of transistor T₃₂ to ground. In the other amplifier 61 similar switches are provided which are operated simultaneously with switches S₂ and S₃. Elements which have to be duplicated for each dual read head are enclosed by a dashed line. The remainder of the balanced arrangement is common to all dual read heads. A dual read head is disabled by closing the switches S₃ and S₄ in both parts of the balanced arrangement. Fast settling is obtained by closing the switches S₁ temporarily.

In the embodiments shown in the Figures certain transistors, for example the transistors T₁, T₂, T₃, T₅ and T₁₀ are preferably unipolar MOS transistors; other transistors such as the transistors T₄, T₂₄, T₆, T₇, T₈, T₉, T₁₁ and T₃₁, are preferably bipolar transistors. It is, however, possible to use bipolar transistors instead of unipolar transistors and vice versa, or to use only bipolar or only unipolar transistors. The first main flow terminal, the second main flow terminal and the control terminal of a transistor correspond to, respectively, the source terminal, the drain terminal and gate terminal of an unipolar transistor and to, respectively, the emitter terminal, the collector terminal and base terminal of a bipolar transistor.

## Claims

1. Arrangement for reading out an information signal from a magnetic record carrier, comprising:
a read head having a magneto-resistive element (Rₘ₁) with a first terminal (3) connected to a first point (13) of constant potential, and with a second terminal (4),
a bias-current means (2; T₃₀,T₃₁) for supplying a bias-current,
an amplifier circuit (1) comprising an output terminal (8) for supplying the information signal (Vₒᵤₜ), a first terminal (6) coupled to the bias-current means (2; T₃₀,T₃₁) and to the output terminal (8), a second terminal (7) coupled to the second terminal (4) of the magneto-resistive element (Rₘ₁) so as to form a series arrangement of the bias-current means (2; T₃₀,T₃₁), the amplifier circuit (1) and the magneto-resistive element (Rₘ₁) between a second point (12) of constant potential and said first point (13) of constant potential, the amplifier circuit (1) further comprising a first transistor (T₁), a feedback circuit (F₁) having an input terminal (t₂) coupled to the output terminal (8) of the amplifier circuit (1) and having an output terminal (t₁), a load impedance (Rₗ₁) and a capacitor element (C₁), a first main flow terminal of the first transistor (T₁) being connected to the second terminal (7) of the amplifier circuit (1), a second main flow terminal of the first transistor (T₁) being coupled to the first terminal (6) of the amplifier circuit (1), a control terminal of the first transistor (T₁) being coupled to the output terminal (t₁) of the feedback circuit (F₁), the control terminal being further coupled to the first point (13) of constant potential via at least the capacitor element (C₁), the load impedance (Rₗ₁) being coupled to the output terminal (8) of the amplifier circuit (1), **characterized in that** the feedback circuit comprises:
voltage buffer means having an input coupled to the input terminal (t₂) of the feedback circuit (F₁) and having an output;
a first series resistor (R₁) connected between the output of the voltage buffer means and the output terminal (t₁) of the feedback circuit (F₁); and
a switch (S₁) connected in parallel with the first series resistor (R₁) and operable in response of a control signal.

2. Arrangement as claimed in claim 1, **characterized in that** the voltage buffer means comprises a first current source (24) and a second current source (21), a second (T₃) transistor having a control terminal connected to a second main flow terminal and a third transistor (T₄), a first main flow terminal of the second transistor (T₃) and a first main flow terminal of the third transistor (T₄) being interconnected and coupled to the first point (13) of constant potential via the first current source (24), the second main flow terminal of the second transistor (T₃) being coupled to the second point (12) of constant potential via the second current source (21) and forming the output of the voltage buffer means, a second main flow terminal of the third transistor being coupled to the second point (12) of constant potential, and a control terminal of the third transistor (T₄) forming the input of the voltage buffer means and being coupled to the input terminal (t₂) of the feedback circuit (F₁).

3. Arrangement as claimed in claim 2, **characterized in that** the voltage buffer means further comprises a third current source (22) connected between the second main flow terminal of the third transistor (T₄) and the second point (12) of constant potential and **in that** the first current source (2) comprises a diode arrangement (25), a bias resistor (R₂₄) and a fourth transistor (T₂₄) having a first main flow terminal connected to the first point (13) of constant potential, a second main flow terminal connected to first main flow terminals of the second (T₃) and third (T₄) transistors and a control terminal coupled to the second main flow terminal of the third transistor (T₄) via the diode arrangement (25) and to the first point (13) of constant potential via the bias resistor (R₂₄).

4. Arrangement as claimed in claim 3, **characterized in that** the voltage buffer means further comprises a fifth transistor (T₅) and a diode element (40), a control terminal and a second main flow terminal of the fifth transistor (T₅) being interconnected and being coupled to the third current source (21) via the diode element (40), a first main flow terminal of the fifth transistor (T₅) being connected to the first main flow terminal of the second transistor (T₃), and a sixth transistor (T₆) having a first main flow terminal coupled to the second main flow terminal of the second transistor (T₃), a second main flow terminal coupled to the second point (12) of constant potential and a control terminal coupled to the second main flow terminal of the fifth transistor (T₅) via the diode element (40).

5. Arrangement as claimed in claim 1, 2, 3 or 4, **characterized in that** the amplifier circuit comprises a seventh transistor (T₇) having a first main flow terminal connected to the second main flow terminal of the first transistor (T₁) and a second main flow terminal coupled to the first terminal (6) of the amplifier circuit (1).

6. Arrangement as claimed in claim 1, 2, 3, 4 or 5, **characterized in that** the amplifier circuit (1) comprises an eighth transistor (T₈) having a control terminal coupled to the second terminal (7) of the amplifier circuit (1), a first main flow terminal coupled to the second point (12) of constant potential via a bias current source (36), and a second main flow terminal coupled to the first point (13) of constant potential, the load impedance (Rₗ₁) being coupled between the output terminal (8) of the amplifier circuit (1) and the first main flow terminal of the eighth transistor (T₈).

7. Arrangement as claimed in claim 5 and 6, **characterized in that** the amplifier circuit (1) further comprises a ninth transistor (T₉) having a first main flow terminal coupled to a control terminal of the seventh transistor (T₇) and a control terminal coupled to the first main flow terminal of the eighth transistor (T₈).

8. Arrangement as claimed in claim 7, **characterized in that** the amplifier circuit (1) further comprises a tenth transistor (T₁₀) having a control terminal coupled to the control terminal of the first transistor (T₁) and having a first main flow terminal coupled to the control terminal of the eighth transistor (T₈).

9. Arrangement as claimed in claim 6, 7 or 8, **characterized in that** the second main flow terminal of the eighth transistor (T₈) is coupled to the first point (13) of constant potential via a further load impedance (Rₗ₁') for providing the information signal.

10. Arrangement as claimed in claim 1, **characterized in that** the first terminal (6) is coupled to the output terminal (8) of the amplifier circuit (1) via a second transistor (T₃₁) having a first main flow terminal connected to the first terminal (6) and a second main flow terminal coupled to the output terminal (8) of the amplifier circuit (1); and **in that** the voltage buffer means comprises:
a current mirror (300) having an input terminal (302) and an output terminal (304),
a third transistor (T₃₀) having a conductivity opposite to the conductivity of the second transistor (T₃₁) and having a first main flow terminal coupled to the output terminal (304) of the current mirror (300) and a control terminal connected to receive a reference voltage,
a second series resistor (Rₐ) connected between the first main flow terminal of the third transistor (T₃₀) and the output terminal (8) of the amplifier circuit (1),
a fourth transistor (T₃₂) of the same type as the first transistor (T₁) having a control terminal connected to a second main flow terminal, and
having a first main flow terminal connected to the first main flow terminal of the first transistor (T₁) and a second main flow terminal coupled to a second main flow terminal of the third transistor (T₃₀),
a fifth transistor (T₃₃) of the same type as the first transistor (T₁) having a control terminal and a first main flow terminal connected to the corresponding terminals of the first transistor (T₁) and having a second main flow terminal coupled to the input terminal (302) of the current mirror (300); and a buffer amplifier (310) having an input connected to the control terminal of the fourth transistor (T₃₂) and an output connected to the first series resistor (R₁).

11. Arrangement as claimed in claim 10, **characterized in that** the bias current means comprises a bias current generator (2) having an output (5) connected to the first terminal (6) of the amplifier circuit (1).

12. Arrangement as claimed in claim 1, 2, 3, 4, 5, 6, 7, 8, 9, 10 or 11, **characterized in that** the switch (S₁) comprises:
first (ST₁) and second (ST₂) switching transistors of a first conductivity type, a first main flow terminal of the first switching transistor (ST₁) being connected to a second main flow terminal of the second switching transistor (ST₂), a second main flow terminal of the first switching transistor (ST₁) being connected to a first main flow terminal of the second switching transistor (ST₂); first (DT₁) and second (DT₂) driver transistors of a second conductivity type having first main flow terminals connected to a supply voltage terminal (12) and having control terminals connected to a control input (100) for receiving the control signal, a second main flow terminal of the first driver transistor (DT₁) being connected to the control terminal of the first switching transistor (ST₁), a second main flow terminal of the second driver transistor (DT₂) being connected to the control terminal of the second switching transistor (ST₂); third (DT₃) and fourth (DT₄) driver transistors of the first conductivity type having control terminals connected to the control input (100), a first main flow terminal of the third driver transistor (DT₃) being connected to the second main flow terminal of the first switching transistor (ST₁), a first main flow terminal of the fourth driver transistor (DT₄) being connected to the second main flow terminal of the second switching transistor (ST₂), a second main flow terminal of the third driver transistor (DT₃) being connected to the second main flow terminal of the first driver transistor (DT₁), a second main flow terminal of the fourth driver transistor (DT₄) being connected to the second main flow terminal of the second driver transistor (DT₂).

13. An arrangement as claimed in any of the preceding claims, further comprising a second arrangement, substantially identical to the first mentioned arrangement, the capacitor element (C₁) of the amplifier circuit (1) of the first arrangement being coupled to the second terminal (67) of the amplifier circuit (61) of the second arrangement and the capacitor element (C₂) of the amplifier circuit (61) of the second arrangement being coupled to the second terminal (7) of the amplifier circuit (1) of the first arrangement.

## Patentansprüche

1. Einrichtung zum Auslesen eines Informationssignals aus einem magnetischen Aufzeichnungsträger, wobei diese Einrichtung die nachfolgenden Elemente umfasst:
- einen Lesekopf mit einem Magnetwiderstandselement (Rₘ₁), mit einer ersten Klemme (3), die mit einem ersten Punkt (13) konstanten Potentials verbunden ist, und mit einer zweiten Klemme (4),
- ein Bias-Strommittel (2; T₃₀, T₃₁) zum Liefern eines Bias-Stromes,
- eine Verstärkerschaltung (1) mit einer Ausgangsklemme (8) zum Liefern des Informationssignals (Vₒᵤₜ), mit einer ersten Klemme (6), die mit dem Bias-Strommittel (2; T₃₀, T₃₁) sowie mit der Ausgangsklemme (8) gekoppelt ist, mit einer zweiten Klemme (7), die mit der zweiten Klemme (4) des Magnetwiderstandselementes (Rₘ₁) gekoppelt ist zum Bilden einer Reihenschaltung aus dem Bias-Strommittel (2; T₃₀, T₃₁), der Verstärkerschaltung (1) und dem Magnetwiderstandselement (Rₘ₁) zwischen einem zweiten Punkt (12) konstanten Potentials und dem genannten ersten Punkt (13) konstanten Potentials, wobei die Verstärkerschaltung (1) weiterhin einen ersten Transistor (T₁) aufweist, eine Rückkopplungsschaltung (F₁) mit einer Eingangsklemme (t₂), die mit der Ausgangsklemme (8) der Verstärkerschaltung (1) gekoppelt ist, und mit einer Ausgangsklemme (t₁), einer Belastungsimpedanz (Rₗ₁) und einem Kondensatorelement (C₁), wobei eine erste Hauptstromklemme des ersten Transistors (T₁) mit der zweiten Klemme (7) der Verstärkerschaltung (1) gekoppelt ist, wobei eine zweite Hauptstromklemme des ersten Transistors (T₁) mit der ersten Klemme (6) der Verstärkerschaltung (1) gekoppelt ist, wobei eine Steuerklemme des ersten Transistors (T₁) mit der Ausgangsklemme (t₁) der Rückkopplungsschaltung (F₁) gekoppelt ist, wobei die Steuerklemme weiterhin über wenigstens das Kondensatorelement (C₁) mit dem ersten Punkt (13) konstanten Potentials gekoppelt ist, wobei die Belastungsimpedanz (Rₗ₁) mit der Ausgangsklemme (8) der Verstärkerschaltung (1) gekoppelt ist, **dadurch gekennzeichnet, dass** die Rückkopplungsschaltung die nachfolgenden Elemente aufweist:
Spannungspuffermittel mit einem Eingang, der mit der Eingangsklemme (t₂) der Rückkopplungsschaltung (F₁) gekoppelt ist, sowie mit einem Ausgang;
einen ersten Reihenwiderstand (R₁), der zwischen dem Ausgang der Spannungspuffermittel und der Ausgangsklemme (t₁) der Rückkopplungsschaltung (F₁) vorgesehen ist; und
einen Schalter (S₁), der zu dem ersten Widerstand (R₁) parallel geschaltet ist und in Reaktion auf ein Steuersignal wirksam ist.

2. Einrichtung nach Anspruch 1, **dadurch gekennzeichnet, dass** die Spannungspuffermittel die nachfolgenden Elemente aufweisen: eine erste Stromquelle (24) und eine zweite Stromquelle (21), einen zweiten (T₃) Transistor, dessen Steuerklemme mit einer zweiten Hauptstromklemme gekoppelt ist, und einen dritten Transistor (T₄), wobei eine erste Hauptstromklemme des zweiten Transistors (T₃) und eine erste Hauptstromklemme des dritten Transistors (T₄) miteinander verbunden sind sowie über die erste Stromquelle (24) mit dem ersten Punkt (13) konstanten Potentials gekoppelt sind, wobei die zweite Hauptstromklemme des zweiten Transistors (T₃) über die zweite Stromquelle (21) mit dem zweiten Punkt (12) konstanten Potentials gekoppelt ist und den Ausgang der Spannungspuffermittel bilden, wobei eine zweite Hauptstromklemme des dritten Transistors mit dem zweiten Punkt (12) konstanten Potentials gekoppelt ist und wobei eine Steuerklemme des dritten Transistors (T₄) den Eingang der Spannungspuffermittel bildet und mit der Eingangsklemme (t₂) der Rückkopplungsschaltung (F₁) gekoppelt ist.

3. Einrichtung nach Anspruch 2, **dadurch gekennzeichnet, dass** die Spannungspuffermittel weiterhin eine dritte Stromquelle (22) enthalten, die zwischen der zweiten Hauptstromklemme des dritten Transistors (T₄) und dem zweiten Punkt (12) konstanten Potentials vorgesehen ist, und dass die erste Stromquelle (2) eine Diodenanordnung (25), einen Bias-Widerstand (R₂₄) und einen vierten Transistor (T₂₄) aufweist, dessen erste Hauptstromklemme mit dem ersten Punkt (13) konstanten Potentials verbunden ist, dessen zweite Hauptstromklemme mit den ersten Hauptstromklemmen des zweiten (T₃) und des dritten Transistors (T₄) verbunden ist und dessen Steuerklemme über die Diodenanordnung (25) mit der zweiten Hauptstromklemme des dritten Transistors (T4) sowie über den Bias-Widerstand (R₂₄) mit dem ersten Punkt (13) konstanten Potentials gekoppelt ist.

4. Einrichtung nach Anspruch 3, **dadurch gekennzeichnet, dass** die Spannungspuffermittel weiterhin die nachfolgenden Elemente aufweisen:
einen fünften Transistor (T₅) und ein Diodenelement (40), wobei eine Steuerklemme und eine zweite Hauptstromklemme des fünften Transistors (T₅) miteinander verbunden sind und über das Diodenelement (40) mit der dritten Stromquelle (21) gekoppelt sind, wobei eine erste Hauptstromklemme des fünften Transistors (T₅) mit der ersten Hauptstromklemme des zweiten Transistors (T₃) verbunden ist,
und einen sechsten Transistor (T₆), von dem eine erste Hauptstromklemme mit der zweiten Hauptstromklemme des zweiten Transistors (T₃) gekoppelt ist, von dem eine zweite Hauptstromklemme mit dem zweiten Punkt (12) konstanten Potentials gekoppelt ist und eine Steuerklemme über das Diodenelement (40) mit der zweiten Hauptstromklemme des fünften Transistors (T₅) gekoppelt ist.

5. Einrichtung nach Anspruch 1, 2, 3 oder 4, **dadurch gekennzeichnet, dass** die Verstärkerschaltung einen siebenten Transistor (T₇) aufweist, dessen erste Hauptstromklemme mit der zweiten Hauptstromklemme des ersten Transistors (T₁) verbunden ist, und dessen zweite Hauptstromklemme mit der ersten Hauptstromklemme (6) der Verstärkerschaltung (1) gekoppelt ist.

6. Einrichtung nach Anspruch 1, 2, 3, 4 oder 5, **dadurch gekennzeichnet, dass** die Verstärkerschaltung (1) einen achten Transistor (T₈) aufweist, dessen Steuerklemme mit der zweiten Klemme (7) der Verstärkerschaltung (1) gekoppelt ist, dessen erste Hauptstromklemme über eine Bias-Stromquelle (36) mit dem zweiten Punkt (12) konstanten Potentials gekoppelt ist, und dessen zweite Hauptstromklemme mit dem ersten Punkt (13) konstanten Potentials gekoppelt ist, wobei die Belastungsimpedanz (Rₗ₁) zwischen der Ausgangsklemme (8) der Verstärkerschaltung (1) und der ersten Hauptstromklemme des achten Transistors (T₈) gekoppelt ist.

7. Einrichtung nach Anspruch 5 und 6, **dadurch gekennzeichnet, dass** die Verstärkerschaltung (1) weiterhin einen neunten Transistor (T₉) aufweist, dessen einer Hauptstromklemme mit einer Steuerklemme des siebenten Transistors (T₇) gekoppelt ist und dessen Steuerklemme mit der ersten Hauptstromklemme des achten Transistors (T₈0 gekoppelt ist.

8. Einrichtung nach Anspruch 7, **dadurch gekennzeichnet, dass** die Verstärkerschaltung (1) weiterhin einen zehnten Transistor (T₁₀) aufweist, dessen Steuerklemme mit der Steuerklemme des ersten Transistors (T₁) gekoppelt ist und dessen erste Hauptstromklemme mit der Steuerklemme des achten Transistors (T₈) gekoppelt ist.

9. Einrichtung nach Anspruch 6, 7 oder 8, **dadurch gekennzeichnet, dass** die zweite Hauptstromklemme des achten Transistors (T₈) über eine weitere Belastungsimpedanz (Rₗ₁') mit dem ersten Punkt (13) konstanten Potentials gekoppelt ist, und zwar zum Schaffen des Informationssignals.

10. Einrichtung nach Anspruch 1, **dadurch gekennzeichnet, dass** die erste Klemme (6) über einen zweiten Transistor (T₃₁) mit der Ausgangsklemme (8) der Verstärkerschaltung (1) gekoppelt ist, wobei eine erste Hauptstromklemme dieses Transistors mit der ersten Klemme (6) verbunden ist und eine zweite Hauptstromklemme mit der Ausgangsklemme (8) der Verstärkerschaltung (1) gekoppelt ist; und dass die Spannungspuffermittel die nachfolgenden Elemente umfassen:
einen Stromspiegel (300) mit einer Eingangsklemme (302) und einer Ausgangsklemme (304),
einen dritten Transistor (T₃₀), dessen Leitfähigkeit der des zweiten Transistors (T₃₁) entgegengesetzt ist und dessen erste Hauptstromklemme mit der Ausgangsklemme (304) des Stromspiegels (300) gekoppelt ist und dessen Steuerklemme eine Bezugsspannung empfängt,
einen zweiten Reihenwiderstand (Rₐ), der zwischen der ersten Hauptstromklemme des dritten Transistors (T₃₀) und der Ausgangsklemme (8) der Verstärkerschaltung (1) vorgesehen ist,
einen vierten Transistor (T₃₂) von demselben Typ wie der erste Transistor (T₁), dessen Steuerklemme mit einer zweiten Hauptstromklemme verbunden ist, und dessen erste Hauptstromklemme mit der ersten Hauptstromklemme des ersten Transistors (T₁) verbunden ist und dessen zweite Hauptstromklemme mit einer zweiten Hauptstromklemme des dritten Transistors (T₃₀) gekoppelt ist,
einen fünften Transistor T₃₃) von demselben Typ wie der erste Transistor (T₁), dessen Steuerklemme und dessen erste Hauptstromklemme mit den entsprechenden Klemmen des ersten Transistors (T₁) verbunden sind und dessen zweite Hauptstromklemme mit der Eingangsklemme (302) des Stromspiegels (300) gekoppelt ist; und
einen Pufferverstärker (310), dessen Eingang mit der Steuerklemme des vierten Transistors (T₃₂) verbunden ist, und dessen Ausgang mit dem ersten Reihenwiderstand (R₁) verbunden ist.

11. Einrichtung nach Anspruch 10, **dadurch gekennzeichnet, dass** die Bias-Strommittel einen Bias-Stromgenerator (2) aufweisen, dessen Ausgang (5) mit der ersten Klemme (6) der Verstärkerschaltung (1) verbunden ist.

12. Einrichtung nach Anspruch 1, 2, 3, 4, 5, 6, 7, 8, 9, 10 oder 11, **dadurch gekennzeichnet, dass** der Schalter (S₁) die nachfolgenden Elemente umfasst:
einen ersten (ST₁) und einen zweiten (ST₂) Schalttransistor von einem ersten Leitungstyp, wobei eine erste Hauptstromklemme des ersten Schalttransistors (ST₁) mit einer zweiten Hauptstromklemme des zweiten Schalttransistors (ST₂) verbunden ist, wobei eine zweite Hauptstromklemme des ersten Schalttransistors (ST₁) mit einer ersten Hauptstromklemme des zweiten Schalttransistors (ST₂) verbunden ist;
einen ersten (DT₁) und einen zweiten (DT₂) Steuertransistor ein einem zweiten Leitungstyp, wobei von diesen beiden die erste Hauptstromklemme mit einer Speisespannungsklemme (12) verbunden ist und die Steuerklemme mit einem Steuereingang (100) verbunden ist zum Empfangen des Steuersignals, wobei eine zweite Hauptstromklemme des ersten Steuertransistors (DT₁) mit der Steuerklemme des ersten Schalttransistors (ST₁) verbunden ist, wobei eine zweite Hauptstromklemme des zweiten Steuertransistors (DT₂) mit der Steuerklemme des zweiten Schalttransistors (ST₂) verbunden ist;
einen dritten (DT₃) und vierten (DT₄) Steuertransistor vom ersten Leitungstyp, wobei von den beiden die Steuerklemme mit dem Steuereingang (100) verbunden ist, wobei eine erste Hauptstromklemme des dritten Steuertransistors (DT₃) mit der zweiten Hauptstromklemme des ersten Schalttransistors (ST₁) verbunden ist, wobei eine erste Hauptstromklemme des vierten Steuertransistors (DT₄) mit der zweiten Hauptstromklemme des zweiten Schalttransistors (ST₂) verbunden ist, wobei eine zweite Hauptstromklemme des dritten Steuertransistors (DT₃) mit der zweiten Hauptstromklemme des ersten Steuertransistors (DT₁) verbunden ist, und wobei eine zweite Hauptstromklemme des vierten Steuertransistors (DT₄) mit der zweiten Hauptstromklemme des zweiten Steuertransistors (DT₂) verbunden ist.

13. Einrichtung nach einem der vorstehenden Ansprüche, wobei diese Einrichtung eine zweite Einrichtung aufweist, die im Wesentlichen der erst genannten Einrichtung nahezu entspricht, wobei das Kondensatorelement (C₁) der Verstärkerschaltung (1) der ersten Einrichtung mit der zweiten Klemme (67) der Verstärkerschaltung (61) der zweiten Einrichtung gekoppelt ist und wobei das Kondensatorelement (C₂) der Verstärkerschaltung (61) der zweiten Einrichtung mit der zweiten Klemme (7) der Verstärkerschaltung (1) der ersten Einrichtung gekoppelt ist.

## Revendications

1. Dispositif pour lire un signal d'informations à partir d'un support d'enregistrement magnétique, comportant:
une tête de lecture ayant un élément magnétorésistif (_{Rm1}) avec une première borne (3) connectée à un premier point (13) du potentiel constant et avec une deuxième borne (4),
un moyen de courant de polarisation (2; T₃₀,T₃₁) pour délivrer un courant de polarisation, un montage amplificateur (1) comportant une borne de sortie (8) pour délivrer le signal d'informations (Vₒᵤₜ), une première borne (6) couplée au moyen de courant de polarisation (2; T₃₀,T₃₁) et à la borne de sortie (8), une deuxième borne (7) couplée à la deuxième borne (4) de l'élément magnétorésistif (Rₘ₁) de manière à constituer un montage en série du moyen de courant de polarisation (2; T₃₀,T₃₁), du montage amplificateur (1) et de l'élément magnétorésistif (Rₘ₁) entre un deuxième point (12) du potentiel constant et ledit premier point (13) du potentiel constant, le montage amplificateur (1) comportant encore un premier transistor (T₁), un circuit de réaction (F₁) ayant une borne d'entrée (t₂) couplée à la borne de sortie (8) du montage amplificateur (1) et ayant une borne de sortie (t₁), une impédance de charge (Rₗ₁) et un élément capacitif (C₁), une première borne de flux principal du premier transistor (T₁) étant connectée à la deuxième borne (7) du montage amplificateur (1), une deuxième borne de flux principal du premier transistor (T₁) étant couplée à la première borne (6) du montage amplificateur (1), une borne de commande du premier transistor (T₁) étant couplée à la borne de sortie (t₁) du circuit de réaction (F₁), la borne de commande étant encore couplée au premier point (13) du potentiel constant par l'intermédiaire d'au moins l'élément capacitif (C₁), l'impédance de charge (Rₗ₁) étant couplée à la borne de sortie (8) du montage amplificateur (1), **caractérisé en ce que** le circuit de réaction comporte:
un moyen tampon de tension ayant une entrée couplée à la borne d'entrée (t₂) du circuit de réaction (F₁) et ayant une sortie;
une première résistance série (R₁) connectée entre la sortie du moyen tampon de tension et la borne de sortie (t₁) du circuit de réaction (F₁); et
un commutateur (S₁) connecté en parallèle à la première résistance série (R₁) et étant commandable en réaction à un signal de commande.

2. Dispositif selon la revendication 1, **caractérisé en ce que** le moyen tampon de tension comporte une première source de courant (24) et une deuxième source de courant (21), des deuxièmes transistors (T₃) ayant une borne de commande connectée à une deuxième borne de flux principal et un troisième transistor (T₄), une première borne de flux principal du deuxième transistor (T₃) et une première borne de flux principal du troisième transistor (T₄) étant interconnectées et étant couplées au premier point (13) du potentiel constant par l'intermédiaire de la première source de courant (24), la deuxième borne de flux principal du deuxième transistor (T₃) étant couplée au deuxième point (12) du potentiel constant par l'intermédiaire de la deuxième source de courant (21) et constituant la sortie du moyen tampon de tension, une deuxième borne de flux principal du troisième transistor étant couplée au deuxième point (12) du potentiel constant, et une borne de commande du troisième transistor (T₄) constituant l'entrée du moyen tampon de tension et étant couplée à la borne d'entrée (t₂) du circuit de réaction (F₁).

3. Dispositif selon la revendication 2, **caractérisé en ce que** le moyen tampon de tension comporte encore une troisième source de courant (22) connectée entre la deuxième borne de flux principal du troisième transistor (T₄) et le deuxième point (12) du potentiel constant et **en ce que** la première source de courant (2) comporte un montage à diodes (25), une résistance de polarisation (R₂₄) et un quatrième transistor (T₂₄) ayant une première borne de flux principal connectée au premier point (13) du potentiel constant, ayant une deuxième borne de flux principal connectée à des premières bornes de flux principal des deuxième (T₃) et troisième (T₄) transistors et ayant une borne de commande couplée à la deuxième borne de flux principal du troisième transistor (T₄) par l'intermédiaire du montage à diodes (25) et au premier point (13) du potentiel constant par l'intermédiaire de la résistance de polarisation (R₂₄).

4. Dispositif selon la revendication 3, **caractérisé en ce que** le moyen tampon de tension comporte encore un cinquième transistor (T₅) et un élément à diode (40), une borne de commande et une deuxième borne de flux principal du cinquième transistor (T₅) étant interconnectées et étant couplées à la troisième source de courant (21) par l'intermédiaire de l'élément à diode (40), une première borne de flux principal du cinquième transistor (T₅) étant connectée à la première borne de flux principal du deuxième transistor (T₃), et un sixième transistor (T₆) ayant une première borne de flux principal couplée à la deuxième borne de flux principal du deuxième transistor (T₃), ayant une deuxième borne de flux principal couplée au deuxième point (12) du potentiel constant et ayant une borne de commande couplée à la deuxième borne de flux principal du cinquième transistor (T₅) par l'intermédiaire de l'élément à diode (40).

5. Dispositif selon la revendication 1, 2, 3 ou 4, **caractérisé en ce que** le montage amplificateur comporte un septième transistor (T₇) ayant une première borne de flux principal connectée à la deuxième borne de flux principal du premier transistor (T₁) et une deuxième borne de flux principal couplée à la première borne (6) du montage amplificateur (1).

6. Dispositif selon la revendication 1, 2, 3, 4 ou 5, **caractérisé en ce que** le montage amplificateur (1) comporte un huitième transistor (T₈) ayant une borne de commande couplée à la deuxième borne 7 du montage amplificateur (1), ayant une première borne de flux principal couplée au deuxième point (12) du potentiel constant par l'intermédiaire d'une source de courant de polarisation (36) et ayant une deuxième borne de flux principal couplée au premier point (13) du potentiel constant, l'impédance de charge (Rₗ₁) étant couplée entre la borne de sortie (8) du montage amplificateur (1) et la première borne de flux principal du huitième transistor (T₈).

7. Dispositif selon les revendications 5 et 6, **caractérisé en ce que** le montage amplificateur (1) comporte encore un neuvième transistor (T₉) ayant une première borne de flux principal couplée à une borne de commande du septième transistor (T₇) et ayant une borne de commande couplée à la première borne de flux principal du huitième transistor (T₈).

8. Dispositif selon la revendication 7, **caractérisé en ce que** le montage amplificateur (1) comporte encore un dixième transistor (T₁₀) ayant une borne de commande couplée à la borne de commande du premier transistor (T₁) et ayant une première borne de flux principal couplée à la borne de commande du huitième transistor (T₈).

9. Dispositif selon la revendication 6, 7 ou 8, **caractérisé en ce que** la deuxième borne de flux principal du huitième transistor (T₈) est couplée au premier point (13) du potentiel constant par l'intermédiaire d'une nouvelle autre impédance de charge (Rₗ₁') pour fournir le signal d'informations.

10. Dispositif selon la revendication 1, **caractérisé en ce que** la première borne (6) est couplée à la borne de sortie (8) du montage amplificateur (1) par l'intermédiaire d'un deuxième transistor (T₃₁) ayant une première borne de flux principal connectée à la première borne (6) et ayant une deuxième borne de flux principal couplée à la borne de sortie (8) du montage amplificateur (1); et **en ce que** le moyen tampon de tension comporte:
un miroir de courant (300) ayant une borne d'entrée (302) et une borne de sortie (304),
un troisième transistor (T₃₀) ayant une conductivité opposée à la conductivité du deuxième transistor (T₃₁) et ayant une première borne de flux principal couplée à la borne de sortie (304) du miroir de courant (300) et ayant une borne de commande connectée de manière à recevoir une tension de référence,
une deuxième résistance série (Rₐ) connectée entre la première borne de flux principal du troisième transistor (T₃₀) et la borne de sortie (8) du montage amplificateur (1),
un quatrième transistor (T₃₂) du même type que le premier transistor (T₁) ayant une borne de commande connectée à une deuxième borne de flux principal, et ayant une première borne de flux principal connectée à la première borne de flux principal du premier transistor (T₁) et ayant une deuxième borne de flux principal couplée à une deuxième borne de flux principal du troisième transistor (T₃₀),
un cinquième transistor (T₃₃) du même type que le premier transistor (T₁) ayant une borne de commande et une première borne de flux principal connectées aux bornes correspondantes du premier transistor (T₁) et ayant une deuxième borne de flux principal couplée à la borne d'entrée (302) du miroir de courant (300); et
un amplificateur séparateur (310) ayant une entrée connectée à la borne de commande du quatrième transistor (T₃₂) et ayant une sortie connectée à la première résistance série (R₁).

11. Dispositif selon la revendication 10, **caractérisé en ce que** le moyen de courant de polarisation comporte un générateur de courant de polarisation (2) ayant une sortie (5) connectée à la première borne (6) du montage amplificateur (1).

12. Dispositif selon la revendication 1, 2, 3, 4, 5, 6, 7, 8, 9, 10 ou 11, **caractérisé en ce que** le commutateur (S₁) comporte:
des premier (ST₁) et deuxième (ST₂) transistors de commutation d'un premier type de conductivité, une première borne de flux principal du premier transistor de commutation (ST₁) étant connectée à une deuxième borne de flux principal du deuxième transistor de commutation (ST₂), une deuxième borne de flux principal du premier transistor de commutation (ST₁) étant connectée à une première borne de flux principal du deuxième transistor de commutation (ST₂); des premier (DT₁) et deuxième (DT₂) transistors d'excitation d'un deuxième type de conductivité ayant des premières bornes de flux principal connectées à une borne de tension d'alimentation (12) et ayant des bornes de commande connectées à une entrée de commande (100) pour recevoir le signal de commande, une deuxième borne de flux principal du premier transistor d'excitation (DT₁) étant connectée à la borne de commande du premier transistor de commutation (ST₁), une deuxième borne de flux principal du deuxième transistor d'excitation (DT₂) étant connectée à la borne de commande du deuxième transistor de commutation (ST₂); des troisième (DT₃) et quatrième (DT₄) transistors d'excitation du premier type de conductivité ayant des bornes de commande connectées à l'entrée de commande (100), une première borne de flux principal du troisième transistor d'excitation (DT₃) étant connectée à la deuxième borne de flux principal du premier transistor de commutation (ST₁), une première borne de flux principal du quatrième transistor d'excitation (DT₄) étant connectée à la deuxième borne de flux principal du deuxième transistor de commutation (ST₂), une deuxième borne de flux principal du troisième transistor d'excitation (DT₃) étant connectée à la deuxième borne de flux principal du premier transistor d'excitation (DT₁), et une deuxième borne de flux principal du quatrième transistor d'excitation (DT₄) étant connectée à la deuxième borne de flux principal du deuxième transistor d'excitation (DT₂).

13. Dispositif selon l'une quelconque des revendications précédentes 1 à 12, comportant encore un deuxième dispositif sensiblement identique au dispositif mentionné en premier lieu, l'élément capacitif (C₁) du montage amplificateur (1) du premier dispositif étant couplé à la deuxième borne (67) du montage amplificateur (61) du deuxième dispositif et l'élément capacitif (C₂) du montage amplificateur (61) du deuxième dispositif étant couplé à la deuxième borne (7) du montage amplificateur (1) du premier dispositif.
